# EUROPEAN PATENT APPLICATION

(11) **EP 4 822 904 A1**
(43) Date of publication of application: **14.10.2026**
(21) Application number: 26171267.3
(22) Date of filing: 08.04.2026
(51) Int. Cl.: H01R 12/59, H01R 4/18, H01R 12/77, H01R 13/646, H01R 13/6587, H01R 13/6594, H01R 31/06

(54) **HIGH-SPEED DIFFERENTIAL PAIR FLAT CABLE WITH MODULAR TWISTED-PAIR DATA CONNECTOR**

(30) Priority: 11.04.2025 US 202563787215 P; 26.03.2026 US 202619629096
(71) Applicant: Aptiv Technologies AG, 8200 Schaffhausen (CH)
(72) Inventor: LEE, Joon, 8200 Schaffhausen (CH); SEIFERT, Kurt, 8200 Schaffhausen (CH); RAGALYI, Steven P., 8200 Schaffhausen (CH)
(74) Representative: Bardehle Pagenberg Partnerschaft mbB Patentanwälte Rechtsanwälte

(57) **Abstract**

A differential pair flat cable includes a planar substrate, signal conductors, a shield conductor, and exposed signal connection pads. The cable also features a slot in the planar substrate and shield conductor, which receives a vertical shield tab of an inner shield terminal to provide mechanical retention and electrical grounding. A connector assembly mounts to the cable end, comprising an inner signal terminal, an inner shield terminal with a vertical tab, an insulative inner housing, and an outer shield terminal. The assembly provides a robust, low-loss connection suitable for high-speed data transmission, with improved signal integrity and electromagnetic compatibility. The design enables easy assembly and reliable performance, making it ideal for various applications, including automotive and industrial networking.

## Description

The subject matter disclosed herein relates to flat high-speed data cables and, in particular, to a high-speed differential pair flat cable with a modular twisted-pair data connector.

The use of flat cables in high-speed data transmission applications has been limited due to various technical challenges. One of the primary issues is the difficulty in constructing shielded flat data cables that are robust and have low insertion loss characteristics. Existing flat cables are often thin and do not support high-speed data capability due to high signal loss and electromagnetic compatibility (EMC) issues. As a result, the attachment of terminals to flat cables has been a significant challenge. Crimping of the terminal onto the flat cable has been used, but it provides inadequate radio frequency (RF) performance for data transmission. Soldering the terminals to the flat cable has also been attempted, but it causes degradation and melting of the flat cable dielectric material.

Previous approaches have focused on developing new interface systems and components to address the limitations of flat cables. For example, some manufacturers have developed round wire components that can be used in high-frequency applications. However, these components are often bulky and expensive, making them less desirable for use in flat cable assemblies. Others have attempted to develop new types of flat cables with improved shielding and signal integrity, but these cables are often difficult to manufacture and assemble. Additionally, the use of modular connectors has been explored, but these connectors often require complex and expensive assembly processes.

Most of the problems are well known to the industry. For these reasons, some original equipment manufacturers (OEMs) avoid using flat cable for applications. Previous approaches have attempted to address the challenges of flat cable assemblies through various means, but none of these approaches have provided a comprehensive solution that combines the features described in this disclosure.

According to one aspect, the techniques described herein relate to a differential pair flat cable, including a planar substrate, at least one signal conductor arranged within the planar substrate, a shield conductor disposed on one or more surfaces of the planar substrate, at least one exposed signal connection pad connected to the signal conductor, and at least one slot defined in an end portion of the planar substrate and an exposed portion of the shield conductor. The slot defines opposed lateral wall surfaces that are configured to mechanically constrain lateral movement of a vertical shield tab of an electrically conductive inner shield terminal received within the slot. An exposed portion of the shield conductor adjacent the slot is configured to be directly attached to the vertical shield tab to provide mechanical retention and electrical grounding.

According to another aspect, the techniques described herein relate to a differential pair flat cable assembly, including a flat cable having a planar substrate and a longitudinal axis. The flat cable includes a differential pair of signal conductors disposed within the planar substrate, signal connection pads exposed at an end of the flat cable, a shield conductor arranged on an outer surface of the planar substrate, and at least one slot extending through the planar substrate and the shield conductor from a first surface to an opposing second surface. The cable assembly further includes a connector assembly mounted to the end of the flat cable. This connector assembly includes an inner signal terminal having a mating contact portion and an attachment tail portion. The attachment tail portion is directly mechanically and electrically attached to the exposed signal connection pads of the differential pair. The connector assembly also includes an electrically conductive inner shield terminal surrounding the inner signal terminal including at least one integral vertical tab extending axially from the inner shield terminal toward the flat cable. The vertical tab is received within the slot of the flat cable, such that opposed lateral surfaces of the slot constrain lateral movement of the inner shield terminal relative to the flat cable, an electrically insulative inner housing radially situated between the inner signal terminal and the inner shield terminal. The connector assembly additionally includes an outer shield terminal mechanically and electrically joined to the inner shield terminal to form a rigid shield terminal assembly prior to engagement with the flat cable.

Embodiments of the present invention will now be described by way of example with reference to the accompanying drawings, in which:
**FIG. 1** shows an exploded isometric view of a differential pair flat cable assembly according to some embodiments.
**FIG. 2A** shows a top view of a differential pair of signal conductors disposed within a differential pair flat cable of the differential pair flat cable assembly of **FIG. 1** according to some embodiments.
**FIG. 2B** shows a bottom view of a shield conductor of the differential pair flat cable of **FIG. 2A** according to some embodiments.
**FIG. 2C** shows a top view of the shield conductor of the differential pair flat cable of **FIG. 2A** according to some embodiments.
**FIG. 2D** shows a top view of an insulative overlay on the shield conductor of the differential pair flat cable of **FIG. 2A** according to some embodiments.
**FIG. 3A** shows a top view of inner signal terminals attached to signal connection pads of the differential pair of signal conductors of the differential pair flat cable of **FIG. 2A** according to some embodiments.
**FIG. 3B** shows a side view of the inner signal terminals attached to the signal connection pads of **FIG. 3A** according to some embodiments.
**FIG. 4** shows an isometric view of a connector assembly of the differential pair flat cable assembly of **FIG. 1** according to some embodiments.
**FIGS. 5A and 5B** show an assembly sequence of attaching the inner signal terminals to the signal connection pads of the differential pair of signal conductors according to some embodiments.
**FIGS. 6A and 6B** show an assembly sequence of assembling an outer shield terminal, an insulative inner housing, and an inner shield terminal to form the connector assembly of **FIG. 4** according to some embodiments.
**FIG.** 7 shows a step of an assembly sequence of assembling the connector assembly of **FIG. 4** to the according to some embodiments.
**FIG. 8** shows another step of an assembly sequence of assembling the connector assembly of **FIG. 4** to the according to some embodiments.
**FIG. 9** shows yet another step of an assembly sequence of assembling the connector assembly of **FIG. 4** to the according to some embodiments.
**FIGS. 10A and 10B** show isometric top and bottom views of the connection points of the inner shield terminal of the connector assembly to the shield conductor of the flat cable according to some embodiments.
**FIG. 11A** shows a side view of the differential pair flat cable assembly of **FIG. 1** with the connector assembly inserted within an insulative outer housing according to some embodiments.
**FIG. 11B** shows an isometric top view of the connector assembly of **FIG. 11A** according to some embodiments.
**FIG. 12** shows a return loss graph for the differential pair flat cable assembly of **FIG. 1** based on computer simulation according to some embodiments.
**FIG. 13** shows a return loss graph for the differential pair flat cable assembly of **FIG. 1** based on measurements of actual samples according to some embodiments.

The problems of utilizing an industry-standard high-speed terminal connector interface for attachment to a high-speed shielded flat cable have been solved by introducing a robust low loss flat cable having a slide-on modular twisted-pair data type connector terminal compatible with H-MTD-type mating connectors or connectors of similar geometry used in automotive networking applications and capable of supporting frequencies up to 20 GHz and data transmission rates up to 56 Gbit/sec. H-MTD^{®} is a registered trademark of Rosenberger Hochfrequenztechnik GmbH & Co.

The following description is provided to enable a person skilled in the art to make and use the invention. Various modifications to the embodiments described herein will be readily apparent to those skilled in the art.

The embodiments described herein relate generally to high-speed flat data cables and connector assemblies, and more particularly to a differential pair flat cable configured to interface with a modular twisted-pair data connector. The disclosed structures enable reliable electrical connection between a flat printed circuit cable and high-speed connector terminals while maintaining desirable mechanical retention and signal integrity characteristics.

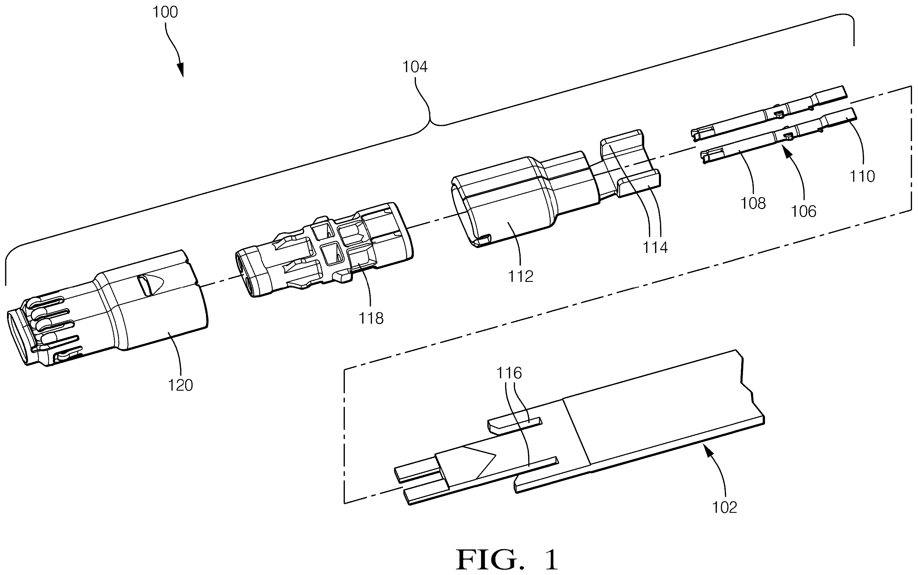

Referring initially to **FIG. 1****,** differential pair flat cable assembly, hereafter referred to as the cable assembly 100, is illustrated. The cable assembly 100 includes a flat cable 102 and a connector assembly 104 mounted to an end portion of the flat cable 102. The connector assembly 104 is configured to provide electrical and mechanical interface between the flat cable 102 and a corresponding mating connector of another electrical cable or electronic device (not shown).

In some embodiments, the connector assembly 104 may conform to the H-MTD^{®} modular twisted-pair data connector interface, which is commonly used in automotive networking applications capable of supporting high-frequency data transmission.

The flat cable 102 may include a flexible printed circuit (FPC) structure including multiple conductive and dielectric layers configured to support high-speed differential signal transmission.

The connector assembly 104 may include inner signal terminals 106, each having a mating contact portion 108 and an attachment tail portion 110. The attachment tail portion 110 is configured to be directly mechanically and electrically attached to the flat cable 102. The connector assembly 104 may also include an electrically conductive inner shield terminal 112 configured to surround the inner signal terminals 106. The inner shield terminal 112 including at least one integral vertical shield tab 114, in the illustrated example two shield tabs 114, extending axially from the inner shield terminal 112 toward the flat cable 102. The vertical shield tab 114 is received within a slot 116 in the flat cable 102, such that opposed lateral surfaces of the slot 116 constrain lateral movement of the inner shield terminal 112 relative to the flat cable 102. The connector assembly 104 may further include an electrically insulative inner housing 118 radially situated between the inner signal terminals 106 and the inner shield terminal 112. The connector assembly 104 may additionally include an outer shield terminal 120 mechanically and electrically joined to the inner shield terminal 112 to form a rigid shield terminal assembly prior to engagement with the flat cable 102. The outer shield terminal 120 provides a mating interface with a corresponding mating connector while the inner shield terminal 112 connects the outer shield terminal 120 to the shield conductor 210.

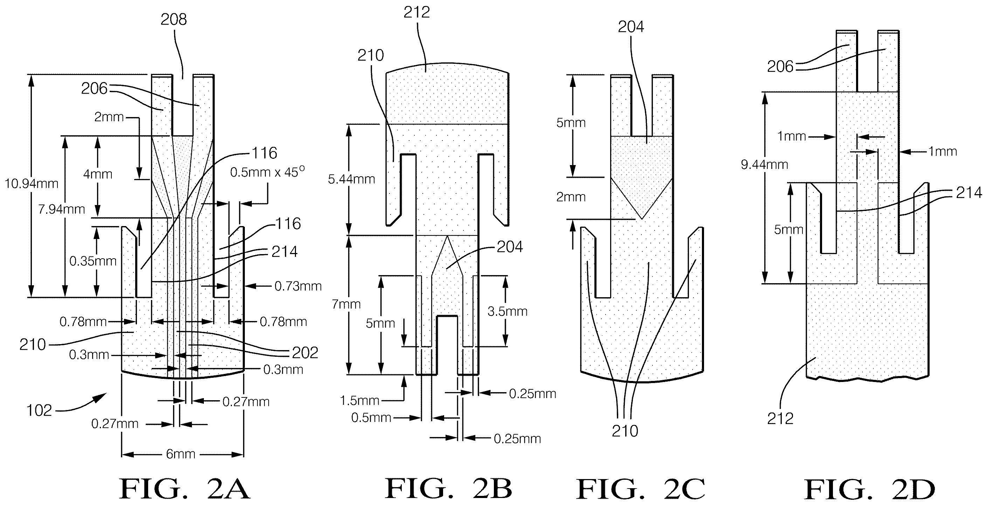

Referring to **FIG. 2A****,** a top view of the flat cable 102 is shown. The signal conductors 202 may be copper traces arranged to form a differential pair transmission line extending longitudinally along the flat cable 102.
The signal conductors 202 terminate at exposed signal connection pads 206 located at an end portion of the flat cable 102. These pads 206 are configured to receive the attachment tail portions 110 of the inner signal terminals 106. A gap 208 may be defined in the planar substrate between the first and second signal connection pads. The gap 208 may be configured to receive a portion of the inner housing 118 or inner shield terminal 112 to maintain symmetric positioning of the inner signal terminals 106 relative to the inner shield terminal 112.

In some embodiments, the signal conductors 202 include periodic crossover regions with an insulation layer of the substrate 204 between them, thereby forming a periodically crossed differential pair configuration that emulates a twisted-pair electromagnetic coupling along the cable length to reduce electromagnetic interference and maintain balanced impedance characteristics.

Referring to **FIG. 2B****,** the flat cable 102 includes signal conductors 202 disposed on or within a planar substrate 204. A shield conductor 210 is positioned along the surface of the substrate 204. The shield conductor 210 may be formed as a continuous metallic layer, such as copper, and may function as an electromagnetic shield for the signal conductors 202.

Returning to **FIG. 2A****,** the flat cable 102 may include transition regions between the pads 206 and the signal conductors 202. In certain embodiments, the ratio of pad length to transition zone length may be approximately 3:4 ±5% and the ratio of conductor width to conductor spacing may remain substantially constant across the transition. These geometric relationships help maintain a target differential impedance. The shield conductor on the bottom surface shown in **FIG. 2B** overlaps the transition region to provide the target differential impedance through the transition region.

Referring to **FIG. 2C****,** a top view of the flat cable 102 is shown illustrating portions of the shield conductor 210 exposed near the cable end. These exposed portions may provide electrical attachment surfaces for the inner shield terminal 112. The shield conductor 210 on the bottom surface of the substrate 204 in FIG. 2B is electrically connected to the shield conductor 210 on the top surface of the substrate 204 in FIG. 2C by conductive surfaces on the edges of the substrate 204 and/or by one or more conductive vias through the substrate 204.

Referring to **FIG. 2D****,** the flat cable 102 may further include an insulative overlay or cover layer 212 disposed over portions of the shield conductor 210. The cover layer 212 may include openings that expose selected conductive areas such as the pads 206 and shield attachment regions 214.

The flat cable 102 may include a layered stack configuration including signal layers, dielectric layers, and shielding layers arranged to provide controlled impedance transmission characteristics. In an example embodiment, the flat cable may include an acrylic-based copper-clad laminate, such as PYRALUX^{®} LF, a polyamide double-sided copper-clad laminate, such as PYRALUX^{®} AP, and/or a high performance epoxy adhesive, such as PYRALUX^{®} HP. PYRALUX^{®} is a trademark of Qnity Electronics, Inc.

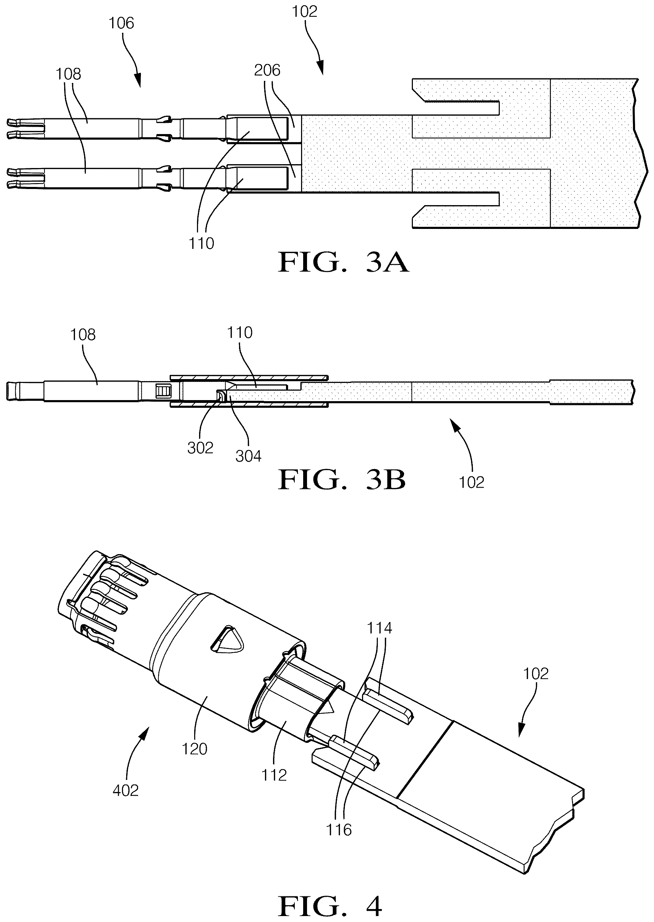

Referring to **FIG. 3A****,** the inner signal terminals 106 are positioned onto the pads 206 of the flat cable. Each inner signal terminal 106 includes the attachment tail portion 110 configured for electrically and mechanically attaching to the pads 206 and the mating contact portion 108 configured to engage a mating connector. In certain embodiments, the pads 206 include exposed copper areas to facilitate reliable attachment of the inner signal terminal 106. Without producing an exhaustive list, the attachment tail portions 110 may be attached to the pads 206, using a soldering process, using a welding process, or using an electrically conductive adhesive.

Referring to **FIG. 3B****,** a side view of the inner signal terminals attached to the pads is shown. The attachment tail portions 110 of the inner signal terminals 106 are attached to the pads 206 to establish electrical connection with the signal conductors 202 of the flat cable 102.

In some embodiments, each inner signal terminal may include a stop surface 302 as shown in **FIG. 3B** which is positioned between the attachment tail portion 110 and the mating contact portion 108. The stop surface 302 may engage an edge 304 of the substrate 204 to establish proper axial positioning of the terminals 106 relative to the flat cable 102.

Referring to **FIG. 4****,** a connector shield terminal assembly 402 is illustrated. The shield terminal assembly may include the outer shield terminal 120, the inner housing 118, and the inner shield terminal 112. The inner housing 118 may be positioned within the outer shield terminal 120, and the inner shield terminal 112 may be attached to the outer shield terminal 120 to form a rigid shield terminal assembly 402. The connector shield terminal assembly 402 may be produced separately prior to installation onto the flat cable 102.

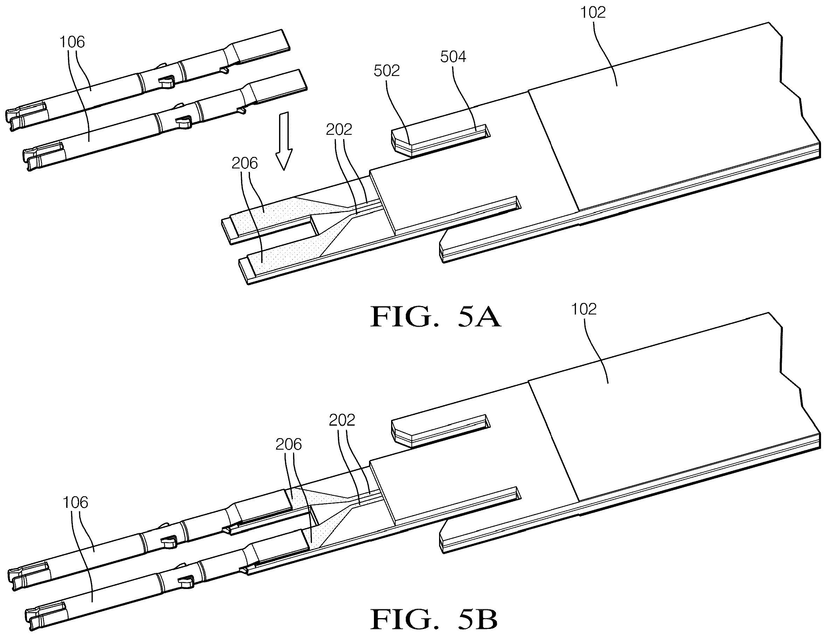

Referring to **FIGS. 5A and 5B****,** an assembly sequence is illustrated for attaching the inner signal terminals 106 to the flat cable 102.

In **FIG. 5A****,** the inner signal terminals 106 are positioned on the exposed pads 206. In **FIG. 5B****,** the inner signal terminals 106 are attached to the pads 206 to form an electrical connection between the inner signal terminals 106 and the signal conductors 202. In some embodiments, a solder paste may be applied to the pads 206 prior to terminal placement to facilitate a soldering process.

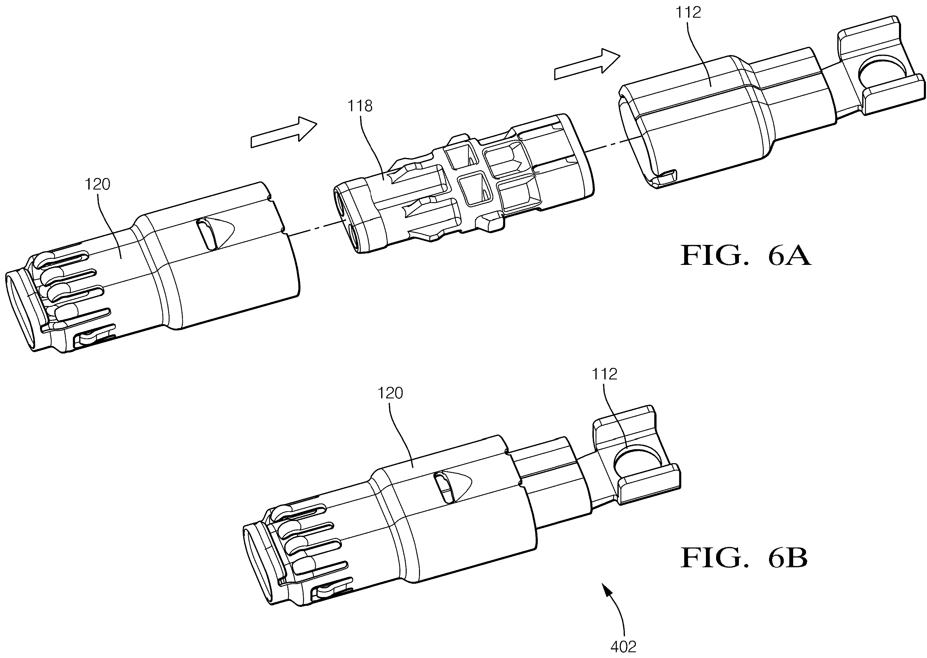

Referring to **FIGS. 6A and 6B****,** the connector shield terminal assembly 402 is installed over the inner signal terminals 106.

The inner shield terminal 112 includes vertical shield tabs 114 extending axially toward the flat cable 102. These shield tabs 114 are configured to be received within the slots 116 defined in the flat cable 102. The slots 116 each have an open end 502 and a closed end 504. The open ends 502 are beveled, for example at a 45° angle from the outer edge of the substrate to the outer wall of the slot 116 to guide the shield tabs 114 into the slots 116.

The slots 116 extend through the substrate 204 and the shield conductor 210 of the flat cable 102. The walls of the slots 116 may have a conductive surface and may electrically and mechanically join the shield conductor 210 on the top surface of the substrate 204 to the shield conductor 210 on the bottom surface of the substrate 204. The walls may be plated with a conductive material, include a conductive layer wrapped over the shield conductor 210, or may define a plurality of conductive vias between the shield conductor 210 on the top surface of the substrate 204 to the shield conductor 210 on the bottom surface of the substrate 204. When the shield tabs 114 are inserted into the slots 116, the lateral surfaces of the slots 116 constrain lateral movement of the connector assembly 104 relative to the flat cable 102. The substrate 204 is semi-rigid and has a bending stiffness that may be sufficient to withstand a longitudinal force in a range of 20 to 40 newtons without bending in a lateral direction perpendicular to application of the longitudinal force. This allows the substrate 204 to push the inner signal terminals 106 into the inner housing 118 without bending.

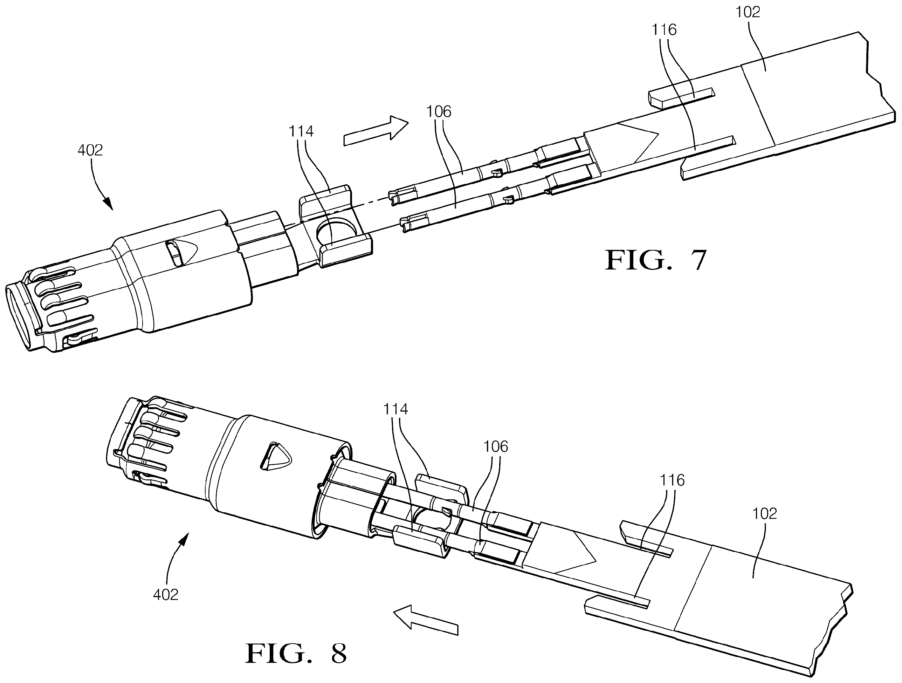

Referring to **FIGS. 7-9****,** the connector assembly 104 is advanced toward the cable end during installation. The vertical shield tabs 114 enter the slots 116 and guide the connector assembly 104 into proper alignment.

Once fully inserted, the shield tabs 114 are mechanically and electrically attached to exposed portions of the shield conductor 210, thereby providing both electrical grounding and mechanical retention of the connector assembly 104 to the flat cable 102. This arrangement provides a robust attachment between the connector assembly and the flat cable.

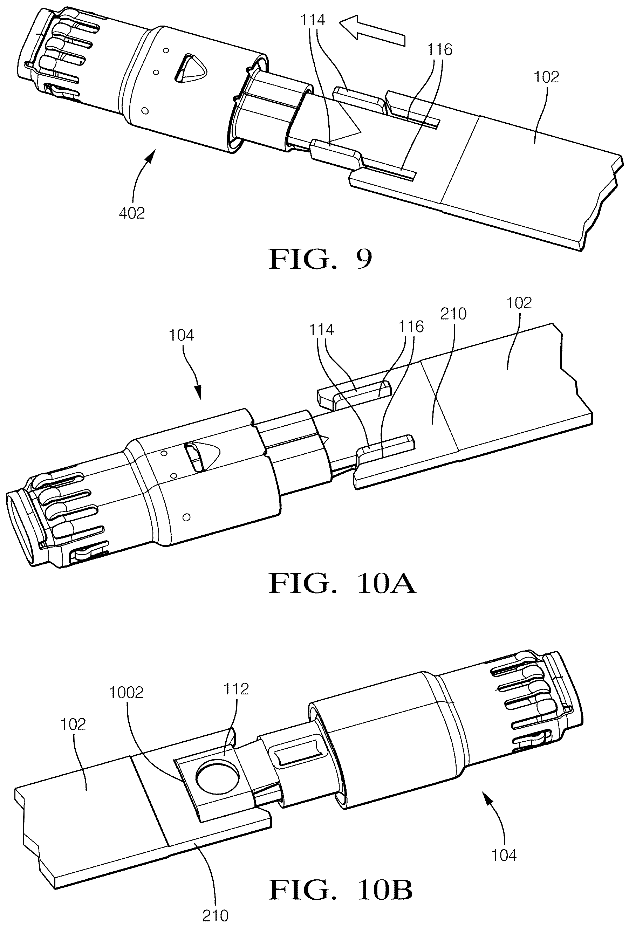

Referring to **FIGS. 10A and 10B****,** the connection interface between the connector assembly and the flat cable is illustrated in greater detail. In some embodiments, a rear tab 1002 of the inner shield terminal 112 as well as the may also engage and be attached to the shield conductor 210, for example by soldering or welding.

The vertical shield tabs 114 extend into the slots 116 and are attached to the shield conductor 210, e.g. using a solder fillet, laser welding, resistance wending, conductive adhesive, or mechanical crimping. This configuration establishes a low-impedance electrical path between the shield conductor 210 and the inner shield terminal 112, thereby improving electromagnetic compatibility.

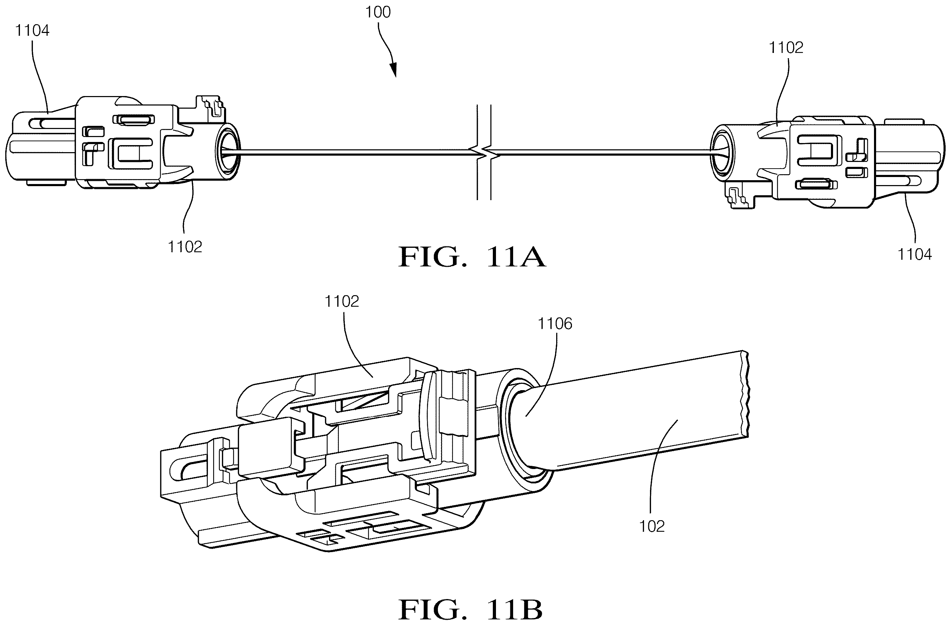

Referring to **FIGS. 11A and 11B****,** the connector assembly may be positioned within an insulative outer housing 1102. The outer housing may include latching features 1104 configured to engage a corresponding mating connector (not shown). As shown in **FIG. 11A****,** the latching features 1104 of each outer housing 1102 are arranged on opposite side of the assembly 100. This allows the proper orientation of the inner signal terminals with a corresponding mating connector. As shown in **FIG. 11B****,** in certain embodiments, the connector housing may include a strain relief region 1106 where an adhesive or epoxy material is applied between the outer housing 1102 and the flat cable 102 to reinforce the cable-to-connector interface.

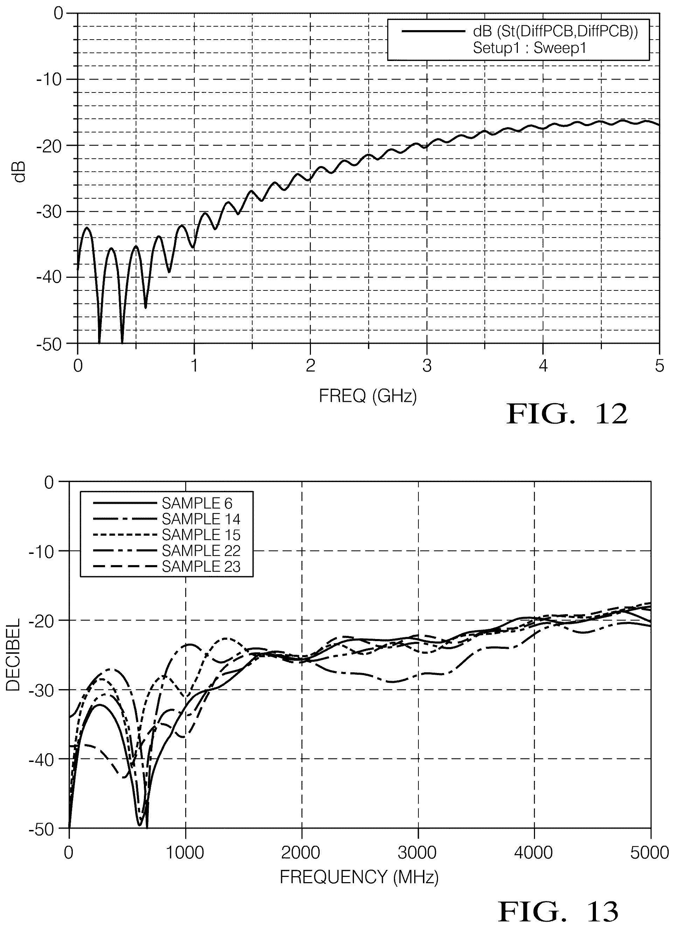

**FIG. 12** shows a simulated return loss graph for the cable assembly and **FIG. 13** shows return loss graphs for several actual samples of the cable assembly. These graphs demonstrate the electrical performance of the differential pair connection system across a range of frequencies.

The cable assembly 100 may be manufactured using modified terminal components derived from existing round-wire connector designs. In some embodiments, the inner signal terminals 106 may be modified to include flat attachment surfaces compatible with the pads 206 and inner shield terminals 112 may be modified to accommodate flat cable entry. In high-volume production, these inner signal terminals 106 may be manufactured using stamped and formed copper alloy components supplied on reels for automated assembly. The assembly process may include:
- placing the inner signal terminals 106 onto the pads 206;
- attaching the inner signal terminals 106 to the pads 206;
- installing the inner shield terminal 112 over the inner signal terminals 106, wherein the inner shield terminal 112 provides clearance to slide over the inner signal terminals 106;
- inserting the shield tabs 114 into the slots 116;
- attaching the shield tabs 114 to the shield conductor 210; and
- installing the outer housing 1102.

The disclosed cable assemblies 100 may be particularly useful in automotive high-speed communication systems, including camera and imaging systems, RADAR and LIDAR sensors, advanced driver assistance systems (ADAS), and vehicle networking architectures. Compared to traditional round twisted-pair cables, the disclosed flat cable structure may enable smaller package size, improved routing flexibility, and simplified integration into compact electronic modules.

Although specific embodiments have been described, various modifications may be made without departing from the scope of the invention. For example:
- the number and position of the shield tabs and the slots may vary.
- alternative connector interface standards may be used,
- a single signal conductor may be used, and/or
- additional signal conductor pairs may be incorporated into the cable assembly.

While the invention has been described with reference to an exemplary embodiment(s), it will be understood by those skilled in the art that various changes may be made, and equivalents may be substituted for elements thereof without departing from the scope of the invention. In addition, many modifications may be made to adapt a particular situation or material to the teachings of the invention without departing from the essential scope thereof. Therefore, it is intended that the invention is not limited to the disclosed embodiment(s), but that the invention will include all embodiments falling within the scope of the appended claims.

As used herein, 'one or more' includes a function being performed by one element, a function being performed by more than one element, e.g., in a distributed fashion, several functions being performed by one element, several functions being performed by several elements, or any combination of the above.

It will also be understood that, although the terms first, second, etc. are, in some instances, used herein to describe various elements, these elements should not be limited by these terms. These terms are only used to distinguish one element from another. For example, a first contact could be termed a second contact, and, similarly, a second contact could be termed a first contact, without departing from the scope of the various described embodiments. The first contact and the second contact are both contacts, but they are not the same contact.

The terminology used in the description of the various described embodiments herein is for the purpose of describing particular embodiments only and is not intended to be limiting. As used in the description of the various described embodiments and the appended claims, the singular forms "a," "an," and "the" are intended to include the plural forms as well, unless the context clearly indicates otherwise. It will also be understood that the term "and/or" as used herein refers to and encompasses any and all possible combinations of one or more of the associated listed items. It will be further understood that the terms "includes," "including," "comprises," and/or "comprising," when used in this specification, specify the presence of stated features, integers, steps, operations, elements, and/or components, but do not preclude the presence or addition of one or more other features, integers, steps, operations, elements, components, and/or groups thereof.

As used herein, the term "if" is, optionally, construed to mean "when" or "upon" or "in response to determining" or "in response to detecting," depending on the context. Similarly, the phrase "if it is determined" or "if [a stated condition or event] is detected" is, optionally, construed to mean "upon determining" or "in response to determining" or "upon detecting [the stated condition or event]" or "in response to detecting [the stated condition or event]," depending on the context.

Additionally, while terms of order or orientation may be used herein these elements should not be limited by these terms. All terms of order or orientation, unless stated otherwise, are used for purposes of distinguishing one element from another, and do not denote any particular order, order of operations, direction or orientation unless stated otherwise.

### Discussion of Possible Embodiments

The following are non-exclusive descriptions of possible embodiments of the present invention.

According to one aspect, the techniques described herein relate to a differential pair flat cable, including a planar substrate, at least one signal conductor arranged within the planar substrate, a shield conductor disposed on one or more surfaces of the planar substrate, at least one exposed signal connection pad connected to the signal conductor, and at least one slot defined in an end portion of the planar substrate and an exposed portion of the shield conductor. The slot defines opposed lateral wall surfaces that are configured to mechanically constrain lateral movement of a vertical shield tab of an electrically conductive inner shield terminal received within the slot. An exposed portion of the shield conductor adjacent the slot is configured to be directly attached to the vertical shield tab to provide mechanical retention and electrical grounding.

The cable of the preceding paragraph can optionally include, additionally and/or alternatively any, one or more of the following features/steps, configurations, and/or additional components.

For example, the end portion of the planar substrate adjacent the slot may be beveled to facilitate insertion of the vertical shield tab into the slot and to align the shield tab relative to the planar substrate.

For example, the end portion of the planar substrate adjacent the slot may be beveled from an outer edge of the planar substrate towards the slot.

For example, the at least one signal conductor may include a first signal conductor and a second signal conductor arranged in a differential pair configuration with the first signal conductor, wherein the at least one exposed signal connection pad includes a first signal connection pad and a second signal connection pad, and wherein the second signal connection pad is arranged parallel to the first signal connection pad.

For example, the first and second signal conductors may have a plurality of crossover points, thereby providing a twisted pair of signal conductors along the planar substrate.

For example, the at least one slot may include a first slot and a second slot arranged parallel to the first slot. The first and second slots may be configured to receive respective vertical shield tabs of the inner shield terminal, such that the opposed lateral walls of the first and second slots constrain lateral movement of the inner shield terminal relative to the planar substrate.

For example, a portion of the planar substrate including the signal connection pads may extend axially beyond the slots. The portion may be configured such that a stop surface of an inner signal terminal engages an edge of the planar substrate to establish axial positioning of the inner shield terminal relative to the flat cable.

For example, a gap may be defined in the planar substrate between the first and second signal connection pads. The gap may be configured to receive a portion of a connector housing or shield structure to maintain symmetric positioning of the differential pair relative to the connector.

For example, the cable may further include first and second transition zones connecting the first signal connection pad to the first signal conductor and the second signal connection pad to the second signal conductor respectively. A ratio of a terminal pad length to a transition zone length may be 3:4 ± 5% to maintain a target differential impedance across the transition zone.

For example, the transition between the signal connection pads and the signal conductors may include a tapered trace geometry configured to maintain differential impedance.

For example, a conductor width-to-gap width ratio remains substantially constant along the transition zone may be substantially constant along the transition zone length to reduce impedance discontinuity between the signal connection pads and a main transmission portion of the flat cable.

For example, the inner signal terminals may be modified round-wire terminals having attachment surfaces configured for attaching to flat cable signal pads.

For example, the signal connection pads may include exposed copper areas configured to receive solder paste for attachment of the inner signal terminals.

For example, the flat cable may include an isolation slot positioned between the signal connection pads to electrically isolate the differential pair terminals.

For example, the connector assembly may further include a strain-relief region filled with an adhesive or epoxy material between the connector housing and the flat cable.

For example, the outer shield terminal includes a rear portion modified to receive the flat cable within the terminal assembly.

For example, the vertical shield tab may extend through the slot until a stop surface of the connector assembly engages the cable end.

For example, the slot may extend through both the planar substrate and the shield conductor of the flat cable.

For example, the slot may be dimensioned to constrain lateral movement of the shield terminal relative to the cable during connector assembly.

According to another aspect, the techniques described herein relate to a differential pair flat cable assembly, including a flat cable having a planar substrate and a longitudinal axis. The flat cable includes a differential pair of signal conductors disposed within the planar substrate, signal connection pads exposed at an end of the flat cable, a shield conductor arranged on an outer surface of the planar substrate, and at least one slot extending through the planar substrate and the shield conductor from a first surface to an opposing second surface. The cable assembly further includes a connector assembly mounted to the end of the flat cable. This connector assembly includes an inner signal terminal having a mating contact portion and an attachment tail portion. The attachment tail portion is directly mechanically and electrically attached to the exposed signal connection pads of the differential pair. The connector assembly also includes an electrically conductive inner shield terminal surrounding the inner signal terminal including at least one integral vertical tab extending axially from the inner shield terminal toward the flat cable. The vertical tab is received within the slot of the flat cable, such that opposed lateral surfaces of the slot constrain lateral movement of the inner shield terminal relative to the flat cable, an electrically insulative inner housing radially situated between the inner signal terminal and the inner shield terminal. The connector assembly additionally includes an outer shield terminal mechanically and electrically joined to the inner shield terminal to form a rigid shield terminal assembly prior to engagement with the flat cable.

The cable assembly of the preceding paragraph can optionally include, additionally and/or alternatively any, one or more of the following features/steps, configurations, and/or additional components.

For example, the vertical tab is mechanically and electrically may be attached directly to the shield conductor on the flat cable.

For example, the connector assembly may be secured to the flat cable by conductive joints at the signal connection pads and the shield conductor.

For example, a bending stiffness of the planar substrate may be sufficient to inhibit deformation of the planar substrate as the inner signal terminal and the inner shield terminal are pushed inside the connector housing.

For example, the bending stiffness may be sufficient to withstand a longitudinal force in a range of 20 to 40 newtons without bending in a lateral direction perpendicular to application of the longitudinal force.

For example, the connector assembly may include an insulative outer housing in which the shield terminal assembly is positioned. The outer housing may include a latching feature configured to secure the connector assembly to a corresponding mating connector assembly.

For example, the cable assembly may include two of the connector assembly placed on each of two ends of the flat cable. The latching feature of one of the connector assemblies on one of the two ends may be arranged on an opposite side of the outer housing relative to the latching feature of another of the connector assemblies on another of the two ends.

For example, the latching feature may include a shark-fin shaped projection configured to be received within an aperture defined by the corresponding mating connector assembly.

For example, the inner signal terminal may define a stop surface between the mating contact portion and an attachment tail portion. The stop surface may be in contact with an end of the planar substrate.

For example, the signal connection pads may be recessed relative to an outer surface of the planar substrate and thereby position an axial centerline of the inner signal terminal to be congruent with an axial centerline of the planar substrate.

According to yet another aspect, the techniques described herein relate to a method of assembling a differential pair flat cable assembly, including the steps of positioning inner signal terminals on exposed signal pads of a flat cable, attaching the inner signal terminals to the signal pads, inserting a shield terminal assembly over the inner signal terminals, inserting at least one shield tab of the shield terminal assembly into a slot in the flat cable, and attaching the shield tab to an exposed portion of a shield conductor of the flat cable.

The method of the preceding paragraph can optionally include, additionally and/or alternatively any, one or more of the following features/steps, configurations, and/or additional components.

For example, the method may further include installing an outer connector housing over the shield terminal assembly.

For example, solder paste may be applied to the signal pads prior to positioning the inner signal terminals.

According to one more aspect, the techniques described herein relate to a differential pair flat cable including a flexible dielectric substrate, a pair of signal conductors forming a differential transmission line, a shield conductor disposed on at least one surface of the substrate, exposed terminal pads connected to the signal conductors, and at least one slot configured to receive a shield tab of a connector assembly.

## Claims

1. A differential pair flat cable (102), comprising:
a planar substrate (204);
at least one signal conductor (202) arranged within the planar substrate (204);
a shield conductor (210) disposed on one or more surfaces of the planar substrate (204);
at least one exposed signal connection pad (206) connected to the signal conductor (202); and
at least one slot (116) defined in an end portion of the planar substrate (204) and an exposed portion of the shield conductor (210), the slot (116) defining opposed lateral wall surfaces configured to mechanically constrain lateral movement of a vertical shield tab (114) of an electrically conductive inner shield terminal (112) received within the slot (116), an exposed portion of the shield conductor (210) adjacent the slot (116) being configured to be directly attached to the vertical shield tab (114) to provide mechanical retention and electrical grounding.

2. The cable (102) according to claim 1, wherein the end portion of the planar substrate (204) adjacent the slot (116) is beveled to facilitate insertion of the vertical shield tab (114) into the slot (116) and to align the shield tab (114) relative to the planar substrate (204), preferably the end portion of the planar substrate (204) adjacent the slot (116) is beveled from an outer edge (304) of the planar substrate (204) towards the slot (116).

3. The cable (102) according to claim 1 or 2, wherein the at least one signal conductor (202) comprises a first signal conductor (202) and a second signal conductor (202) arranged in a differential pair configuration with the first signal conductor (202), wherein the at least one exposed signal connection pad (206) comprises a first signal connection pad (206) and a second signal connection pad (206), and wherein the second signal connection pad (206) is arranged parallel to the first signal connection pad (206), preferably the first and second signal conductors (202) have a plurality of crossover points, thereby providing a twisted pair of signal conductors (202) along the planar substrate (204).

4. The cable (102) according to any one of the preceding claims, wherein the at least one slot (116) comprises a first slot (116) and a second slot (116) arranged parallel to the first slot (116), wherein the first and second slots (116) are configured to receive respective vertical shield tabs (114) of the inner shield terminal (112), such that the opposed lateral walls of the first and second slots (116) constrain lateral movement of the inner shield terminal (112) relative to the planar substrate (204).

5. The cable (102) according to claim 4, wherein a portion of the planar substrate (204) comprising the signal connection pads (206) extends axially beyond the slots (116), the portion configured such that a stop surface (302) of an inner signal terminal (106) engages an edge (304) of the planar substrate (204) to establish axial positioning of the inner shield terminal (112) relative to the flat cable (102).

6. The cable (102) according to claim 5, wherein a gap (208) is defined in the planar substrate (204) between the first and second signal connection pads (206), the gap (208) configured to receive a portion of a connector housing (1102) or shield structure (402) to maintain symmetric positioning of the differential pair (202) relative to the connector.

7. The cable (102) according to any one of the preceding claims when combined with claim 3, wherein the cable (102) further comprises first and second transition zones connecting the first signal connection pad (206) to the first signal conductor (202) and the second signal connection pad (206) to the second signal conductor (202) respectively, wherein a ratio of a terminal pad length to a transition zone length is 3:4 ± 5% to maintain a target differential impedance across the transition zone.

8. The cable (102) according to claim 7, wherein a conductor width to conductor gap width ratio and a ratio of conductor to conductor gap width ratio are substantially constant along the transition zone length to reduce impedance discontinuity between the signal connection pads (206) and a main transmission portion of the flat cable (102).

9. A differential pair flat cable assembly (100), comprising:
a flat cable (102) having a planar substrate (204) and a longitudinal axis, the flat cable (102) comprising:
a differential pair of signal conductors (202) disposed within the planar substrate (204),
signal connection pads (206) exposed at an end of the flat cable (102),
a shield conductor (210) arranged on an outer surface of the planar substrate (204), and
at least one slot (116) extending through the planar substrate (204) and the shield conductor (210) from a first surface to an opposing second surface; and
a connector assembly (104) mounted to the end of the flat cable (102), the connector assembly (104) comprising:
an inner signal terminal (106) having a mating contact portion (108) and an attachment tail portion (110), the attachment tail portion (110) being directly mechanically and electrically attached to the exposed signal connection pads (206) of the differential pair,
an electrically conductive inner shield terminal (112) surrounding the inner signal terminal (106) including at least one integral vertical tab (114) extending axially from the inner shield terminal (112) toward the flat cable (102), the vertical tab (114) received within the slot (116) of the flat cable (102), such that opposed lateral surfaces of the slot (116) constrain lateral movement of the inner shield terminal (112) relative to the flat cable (102),
an electrically insulative inner housing (118) radially situated between the inner signal terminal (106) and the inner shield terminal (112), and
an outer shield terminal (120) mechanically and electrically joined to the inner shield terminal (112) to form a rigid shield terminal assembly (402) prior to engagement with the flat cable (102).

10. The cable assembly (100) according to claim 9, wherein the vertical tab (114) is mechanically and electrically attached directly to the shield conductor (210) on the flat cable (102).

11. The cable assembly (100) according to claim 9 or 10, wherein the connector assembly (104) is secured to the flat cable (102) by conductive joints at the signal connection pads (206) and the shield conductor (210).

12. The cable assembly (100) according to any one of the preceding claims 9 to 11, wherein a bending stiffness of the planar substrate (204) is sufficient to inhibit deformation of the planar substrate (204) as the inner signal terminal (106) and the inner shield terminal (112) are pushed inside the connector housing, preferably the bending stiffness is sufficient to withstand a longitudinal force in a range of 20 to 40 newtons without bending in a lateral direction perpendicular to application of the longitudinal force.

13. The cable assembly (100) according to any one of the preceding claims 9 to 12, wherein the connector assembly (104) comprises an insulative outer housing (1102) in which the shield terminal assembly is positioned and wherein the outer housing (1102) comprises a latching feature configured to secure the connector assembly (104) to a corresponding mating connector assembly (104).

14. The cable assembly (100) according to claim 13, wherein the cable assembly (100) includes two of the connector assembly (104) placed on each of two ends of the flat cable (102) and wherein the latching feature (1104) of one of the connector assemblies (104) on one of the two ends is arranged on an opposite side of the outer housing (1102) relative to the latching feature (1104) of another of the connector assemblies (104) on another of the two ends, preferably the latching feature (1104) comprises a shark-fin shaped projection configured to be received within an aperture defined by the corresponding mating connector assembly.

15. The cable assembly (100) according to claim 14, wherein the inner signal terminal (106) defines a stop surface (302) between the mating contact portion (108) and an attachment tail portion (110) and wherein the stop surface (302) is in contact with an end of the planar substrate (204), preferably the signal connection pads (206) are recessed relative to an outer surface of the planar substrate (204) and thereby position an axial centerline of the inner signal terminal to be congruent with an axial centerline of the planar substrate (204).
